(19) Europäisches Patentamt
European Patent Office
Office européen des brevets

(11) **EP 1 164 211 A1**

(12) **EUROPEAN PATENT APPLICATION**
published in accordance with Art. 158(3) EPC

(43) Date of publication:
**19.12.2001 Bulletin 2001/51**

(51) Int Cl.7: **C30B 29/36**

(21) Application number: **99961385.4**

(86) International application number:
**PCT/JP99/07299**

(22) Date of filing: **24.12.1999**

(87) International publication number:
**WO 00/39372 (06.07.2000 Gazette 2000/27)**

(84) Designated Contracting States:
**AT BE CH CY DE DK ES FI FR GB GR IE IT LI LU MC NL PT SE**
Designated Extension States:
**AL LT LV MK RO SI**

(30) Priority: **25.12.1998 JP 36856598**

(71) Applicant: **SHOWA DENKO KABUSHIKI KAISHA Tokyo 105-8518 (JP)**

(72) Inventors:
• YANO, Kotaro,
Showa Denko K.K. Central Res. Lab.
Chiba-shi, Chiba 267-0056 (JP)
• YAMAMOTO, Isamu,
Showa Denko KK Central Res. Lab.
Chiba-shi, Chiba 267-0056 (JP)
• SHIGETO, Masashi,
Showa Denko KK Central Res. Lab.
Chiba-shi, Chiba 267-0056 (JP)
• NAGATO, Nobuyuki,
Showa Denko KK Central Res. Lab.
Chiba-shi, Chiba 267-0056 (JP)

(74) Representative: **Strehl Schübel-Hopf & Partner Maximilianstrasse 54 80538 München (DE)**

(54) **METHOD FOR GROWING SINGLE CRYSTAL OF SILICON CARBIDE**

(57)     In feeding a silicon carbide-forming gas generated by a method of heat-subliming silicon carbide or the like to the surface of a seed crystal (2) so as to grow a silicon carbide single crystal (3) on the seed crystal, the temperature gradient from the back surface of the seed crystal (2) toward the crucible cap (8) side is rendered zero or a positive value, whereby the back surface sublimation from the back surface of the seed crystal (2) is prevented or suppressed.

Furthermore, by allowing the inner wall of the growth vessel in the periphery of the seed crystal to have a temperature higher than the temperature on the surface of the seed crystal (2), a polycrystal silicon carbide is prevented or suppressed from growing and thereby inhibiting the growth of a silicon carbide single crystal (3).

Fig.1

## Description

CROSS REFERENCE TO RELATED APPLICATIONS

This application is an application filed claiming benefit pursuant to 35 U.S.C. §119(e)(i) of the filing date of the Provisional Application 60/115497 filed on January 11, 1999.

TECHNICAL FIELD

The present invention relates to a method and an apparatus for growing a silicon carbide single crystal and, more specifically, the present invention relates to a method and an apparatus for growing a high-quality silicon carbide single crystal having a large crystal diameter or size on a seed crystal. Silicon carbide is a thermally and chemically very stable semiconductor material having a wide energy band gap and can be used as an environment-resistant-device material, a radiation-resistant-device material, a power-device material for power control, a short wavelength light-emitting device material, and the like, which are usable even at high temperatures.

BACKGROUND ART

The silicon carbide single crystal is usually produced by a sublimation method (see, Japanese Unexamined Patent Publication (Kohyo) No. 3-501118). In the sublimation method, a silicon carbide raw material powder and a seed crystal substrate as a silicon carbide single crystal are placed in a graphite-made crucible to face each other, the crucible is heated at 1,800 to 2,400°C in an inert gas atmosphere to decompose and then gasify the silicon carbide raw material powder by heat and the generated sublimate chemical species is allowed to reach the surface of the seed crystal substrate kept at a temperature suitable for the growth of crystal, whereby the single crystal is epitaxially grown.

The silicon carbide single crystal is required to have a small number of defects because, for example, the single crystal can be advantageously used with high efficiency in the manufacture of a device from the single crystal.

In the inside of a crystal produced by a conventional method, a large number of defects are usually present. One cause of defects is considered to be as follows. As described in Japanese Unexamined Patent Publication (Kokai) No. 9-110584 and Phys. Stat. Sol. (b), vol. 202, 177-200 (1997), when a clearance is present between the back surface of the seed crystal and a holding member for holding the seed crystal, the crystal component sublimes from the clearance on the back surface of the seed crystal (hereinafter referred to as "back surface sublimation") and this gives rise to defects of the seed crystal and the grown crystal. In order to prevent this generation of defects, a method of bonding the seed crystal and the holding member by a polymer adhesive and carbonizing it under heat, as an attempt to improve the adhesive property therebetween, is used (see, for example, Japanese Unexamined Patent Publication (Kokai) No. 9-110584). However, since the polymer material originally undergoes gas generation or volume shrinkage upon carbonization, a sufficiently dense. carbonized layer cannot be formed and a clearance is generated and, as a result, the defects cannot be satisfactorily prevented. In another attempt, as described in Mater. Sci. Engineering B57, 228-233 (1999), a tantalum member is disposed within the growth vessel so as to prevent the back surface sublimation. However, if silicon and a substance other than carbon are used within the growth vessel, these are taken into the crystal as undesired impurities and give rise to a decrease in the quality of the crystal.

Accordingly, a method and an apparatus for producing a high-quality silicon carbide single crystal, reduced in defects and undesired impurities, by preventing the back surface sublimation causing crystal defects are required.

Another cause of producing crystal defects is considered to be as follows. When the crystal is continuously grown for a long period of time, a polycrystal grown from the upper inner wall of the crucible comes to overwhelm the periphery of the single crystal grown on a seed crystal and thereby, strain is. generated in the single crystal, giving rise to the defects. In addition, the polycrystal prevents the enlargement of aperture of the single crystal. In order to produce a crystal while not allowing a polycrystal to grow from the upper inner wall of the crucible and overwhelm the periphery of the single crystal grown on a seed crystal or for producing the single crystal with a large diameter or size, (1) a method described in Shinku (Vacuum), vol. 30 (1987), where a seed crystal substrate is fixed to the ceiling of a graphite crucible and the inner wall of crucible is kept apart from the periphery of seed crystal substrate, so that the grown crystal can be prevented from contacting with the inner wall and thereby, the cause of inhibiting the enlargement of crystal aperture can be eliminated, or (2) a method of fixing a dividing plate having a diameter or size slightly smaller than the seed to the position at a distance of 0.1 to 2.0 mm from the seed crystal substrate so as to enlarge the crystal diameter or size (see, Japanese Unexamined Patent Publication No. 2-30699), is being used at present. In addition, a method of controlling the gradient between the seed crystal substrate and the silicon carbide raw material powder within the reaction vessel is known (see, Japanese Examined Patent Publication (Kokoku) No. 63-57400), where, however, the enlargement of the crystal aperture is not referred to.

These methods have a limit in that since the polycrystal grows at a high rate, the polycrystal comes in contact with the single crystal and at that time, the single crystal stops enlarging. In order to continue the growth, the polycrystal part overwhelming the single crystal must be removed by cutting or the like and this disadvantageously increases the operation steps and decreases the production efficiency of crystal. Furthermore, when the single crystal is overwhelmed with the polycrystal, the single crystal cannot grow to have a large diameter or size. In the method of separating the seed crystal from the upper inner wall of growth vessel, sublimation of seed crystal may disadvantageously occur depending on the production conditions.

The present invention has been made under these circumstances and the object of the present invention is to provide a silicon carbide single crystal reduced in defects and having a large aperture, and a method and an apparatus therefor.

DISCLOSURE OF THE INVENTION

In order to achieve the above-described objects, the present invention provides the followings.

(1) A method for growing a silicon carbide single crystal on a silicon carbide seed crystal, comprising

holding a silicon carbide seed crystal within a growth vessel,
providing a silicon carbide-forming gas feed part in the first surface side of the silicon carbide seed crystal, and
feeding a silicon carbide-forming gas from the silicon carbide-forming gas feed part to the first surface of the silicon carbide seed crystal, wherein the first surface of the silicon carbide seed crystal has a first temperature, the silicon carbide-forming gas feed part has a second temperature higher than the first temperature and, thereby, a silicon carbide single crystal grows on the first surface of the silicon carbide seed crystal,
wherein the silicon carbide seed crystal has a second surface in the opposite side to the first surface and the temperature gradient in the direction from the first surface of the silicon carbide seed crystal to the second surface is zero or a positive value in the outer vicinity of the second surface of the silicon carbide seed crystal.

(2) The method for growing a silicon carbide single crystal as described in (1), wherein a holding member for holding the silicon carbide seed crystal is present adjacent to the second surface of the silicon carbide seed crystal.
(3) The method for growing a silicon carbide single crystal as described in (1) or (2), wherein the region having said temperature gradient of zero or a positive value has a length of at least 1 mm starting from the second surface of the silicon carbide seed crystal in the direction from the first surface toward the second surface of the silicon carbide seed crystal.
(4) The method for growing a silicon carbide single crystal as described in (1) to (3), wherein the temperature gradient is in the range from 0 to 20°C/cm.
(5) The method for growing a silicon carbide single crystal as described in (1) to (4), wherein the first surface of the silicon carbide seed crystal has the first temperature and the wall surface of the growth vessel surrounding in the periphery of the silicon carbide seed crystal has a third temperature higher than the first temperature
(6) The method for growing a silicon carbide single crystal as described in (5), wherein the third temperature is from 10 to 400°C higher than the first temperature.
(7) The method for growing a silicon carbide single crystal as described in (1) to (6), wherein in the silicon carbide-forming gas feed part, the silicon carbide powder is heated to sublimate silicon carbide.
(8) The method for growing a silicon carbide single crystal as described in (1) to (6), wherein in the silicon carbide-forming gas feed part, a vaporized gas from a silicon raw material is passed through heated carbon to form a silicon carbide-forming gas.
(9) The method for growing a silicon carbide single crystal as described in (5) to (8), wherein the first temperature is a temperature in the range from 1,500 to 2,500°C.
(10) The method for growing a silicon carbide single crystal as claimed in claim 1, wherein a vertical growth vessel is used and heating means are selectively disposed in the upper and lower parts of the silicon carbide seed crystal in the growth vessel or heating means for performing the heating of the upper and lower portions of the silicon carbide seed crystal to a temperature higher than the temperature in the vicinity of the silicon carbide seed crystal is disposed in the growth vessel, such that the silicon carbide-forming gas feed part has a temperature higher than the temperature on the first surface of the silicon carbide seed crystal and said temperature gradient is zero or a positive value and optionally, such that the wall surface of the growth vessel surrounding in the periphery of the silicon carbide seed crystal has a temperature higher than the temperature on the first surface of the silicon carbide seed crystal.
(11 The method for growing a silicon carbide single crystal as described in (1) to (10), wherein the first temperature is from 1,900 to 2,300°C, said temperature gradient is in the range from 0 to 20°C/cm, the wall surface of the growth vessel facing the second surface of the silicon carbide seed crystal has a third temperature higher than the first temperature, and the third temperature is a temperature from 50 to 300°C higher than the first temperature.
(12) The method for growing a silicon carbide single crystal as described in (1) to (11), wherein the silicon carbide single crystal growing on the silicon carbide seed crystal grows while enlarging the width in the direction perpendicular to the thickness direction of the grown crystal.

(13) The method for growing a silicon carbide single crystal as described in (1) to (12), wherein the silicon carbide single crystal growing on the silicon carbide seed crystal grows to have substantially the same width in the direction perpendicular to the thickness direction of the grown crystal.

(14) The method for growing a silicon carbide single crystal as described in (1) to (12), wherein the silicon carbide single crystal growing on the silicon carbide seed crystal grows while enlarging the width in the direction perpendicular to the thickness direction of the grown crystal and thereafter grows with substantially the same width.

(15) A method for growing a silicon carbide single crystal on a silicon carbide seed crystal, comprising

holding a silicon carbide seed crystal within a growth vessel,
providing a silicon carbide-forming gas feed part in the first surface side of the silicon carbide seed crystal, and
feeding a silicon carbide-forming gas from the silicon carbide-forming gas feed part to the first surface of the silicon carbide seed crystal, wherein the first surface of the silicon carbide seed crystal has a first temperature, the silicon carbide-forming gas feed part has a second temperature higher than the first temperature and, therefore, a silicon carbide single crystal is grown on the first surface of the silicon carbide seed crystal,
wherein the first surface of the silicon carbide seed crystal has a first temperature and the wall surface of the growth vessel surrounding in the periphery of the silicon carbide seed crystal has a third temperature higher than the first temperature.

(16) The method for growing a silicon carbide single crystal as described in (15), wherein a holding member is provided to project inside the growth vessel from the vessel wall of the growth vessel and hold the silicon carbide seed crystal at its distal end, the holding member passes through the vessel wall, the holding member is higher in the heat dissipation than the surrounding vessel wall and the third temperature is higher than the first temperature.

(17) The method for growing a silicon carbide single crystal as described in (15) or (16), wherein the holding member is rendered to have heat dissipation higher than that of the surrounding vessel wall by forming the holding member using a carbon material having heat conductivity anisotropy such that the heat conductivity is higher in the heat dissipation direction than in other directions.

(18) The method for growing a silicon carbide single crystal as described in (15) to (17), wherein the third temperature is from 10 to 400°C higher than the first temperature.

(19) A method for growing a silicon carbide single crystal, comprising

holding a silicon carbide seed crystal within a growth vessel,
providing a silicon carbide-forming gas feed part in the first surface side of the silicon carbide seed crystal, and
feeding a silicon carbide-forming gas from the silicon carbide-forming gas feed part to the first. surface of the silicon carbide seed crystal, wherein the first surface of the silicon carbide seed crystal has a first temperature, the silicon carbide-forming gas feed part has a second temperature higher than the first temperature and, thereby, a silicon carbide single crystal is grown on the first surface of the silicon carbide seed crystal,
wherein a holding member is provided to project inside the growth vessel from a first vessel wall of the growth vessel facing the second surface of the silicon carbide seed crystal in the side opposite the first surface and hold the silicon carbide seed crystal at its distal end, the holding member passes through the first vessel wall, and the holding member is higher in the heat dissipation than the vessel wall.

(20) The method for growing a silicon carbide single crystal as described in (19), wherein the holding member is rendered to have heat dissipation higher than that of the first vessel wall by forming the holding member using a carbon material having heat conductivity anisotropy such that the heat conductivity is higher in the heat dissipation direction than in other directions.

(21) The method for growing a silicon carbide single crystal as described in (19) or (20), wherein a carbon material having heat conductivity anisotropy such that the heat conductivity is higher in the heat dissipation direction than in other directions is used for the first vessel wall.

(22) The method for growing a silicon carbide single crystal as described in (19) to (21), wherein both the carbon materials having heat conductivity anisotropy used for the holding member and the first vessel wail are pyrographite carbon.

(23) An apparatus for growing a silicon carbide single crystal on a silicon carbide seed crystal, comprising

a growth vessel,
means for holding a silicon carbide seed crystal within the growth vessel, the silicon carbide seed crystal having a first surface and in the opposite side thereof, a second surface,

a silicon carbide-forming gas feed part for feeding a silicon carbide-forming gas to the first surface of the silicon carbide seed crystal, which is provided in the first surface side of the silicon carbide seed crystal,

first heating means for heating the silicon carbide-forming gas feed part to give a second temperature to the silicon carbide-forming gas feed part, the second temperature being higher than the first temperature on the first surface of the silicon carbide seed crystal, and

second heating means for heating a portion of the growth vessel in the second surface side of the silicon carbide seed crystal, the temperature gradient in the direction from the first surface toward the second surface of the silicon carbide seed crystal being zero or a positive value in the outer vicinity of the first surface of the silicon carbide seed crystal.

(24) The apparatus for growing a silicon carbide single crystal as described in (23) wherein, in the silicon carbide-forming gas feed part, silicon carbide powder is heated to sublimate silicon carbide and form a silicon carbide-forming gas.

(25) The apparatus for growing a silicon carbide single crystal as described in (23) or (24) wherein, in the silicon carbide-forming gas feed part, a vaporized gas from a silicon raw material is passed through heated carbon to form a silicon carbide-forming gas.

(26) The apparatus for growing a silicon carbide single crystal as described in (23) to (25), wherein the temperature gradient is in the range from 0 to 20°C/cm.

(27) The apparatus for growing a silicon carbide single crystal as described in (23) to (26), wherein the first surface of the silicon carbide seed crystal has a first temperature and the wall surface of the growth vessel surrounding in the periphery of the silicon carbide seed crystal has a third temperature higher than the first temperature.

(28) The apparatus for growing a silicon carbide single crystal as described in (23) to (27), wherein the third temperature is from 10 to 400°C higher than the first temperature.

(29) An apparatus for growing a silicon carbide single crystal on a silicon carbide seed crystal, comprising

a growth vessel,
means for holding a silicon carbide seed crystal within the growth vessel, the silicon carbide seed crystal having a first surface and, on the opposite side thereof, a second surface,

a silicon carbide-forming gas feed part for feeding a silicon carbide-forming gas to the first surface of the silicon carbide seed crystal, which is provided in the first surface side of the silicon carbide seed crystal, and

first heating means for heating the silicon carbide-forming gas feed part to give a second temperature to the silicon carbide-forming gas feed part, the second temperature being higher than the first temperature on the first surface of the silicon carbide seed crystal,

wherein the temperature on the wall surface of the growth vessel surrounding in the periphery of the silicon carbide seed crystal is higher than the temperature on the first surface of the silicon carbide seed crystal.

(30) The apparatus for growing a silicon carbide single crystal as described in (29), wherein the silicon carbide seed crystal-holding means is constructed by a member hating heat dissipation higher than that of the vessel wall of the growth vessel through which the silicon carbide seed crystal-holding means passes, whereby the temperature on the wall surface of the growth vessel facing the second surface of the silicon carbide seed crystal is made higher than the temperature on the first surface of the silicon carbide seed crystal.

(31) The apparatus for growing a silicon carbide single crystal as described in (29) or (30), wherein the silicon carbide seed crystal-holding means is formed of a carbon material having heat conductivity anisotropy sucb that the heat conductivity is higher in the heat dissipation direction than in other directions.

(32) The apparatus for growing a silicon carbide single crystal as described in (29) to (31), wherein the temperature on the wall surface of the growth vessel surrounding in the periphery of the silicon carbide seed crystal is from 10 to 400°C higher than the temperature on the first surface of the silicon carbide seed crystal.

(33) An apparatus for growing a silicon carbide single crystal on a silicon carbide seed crystal, comprising

a growth vessel,
means for holding a silicon carbide seed crystal within the growth vessel, the silicon carbide seed crystal having a first surface and, on the opposite side thereof, a second surface,

a silicon carbide-forming gas feed part for feeding a silicon carbide-forming gas to the first surface of the silicon carbide seed crystal, which is provided in the first surface side of the silicon carbide seed crystal, and

first heating means for heating the silicon carbide-forming gas feed part to give a second temperature to the silicon carbide-forming gas feed part, the second temperature being higher than the first temperature on the first surface of the silicon carbide seed crystal,

wherein the silicon carbide seed crystal-holding means projects inside the growth vessel from the vessel wall of the growth vessel, passes through the vessel wall and is constructed by a member having heat dissipation higher than that of the first vessel wall of the growth vessel facing the second surface of the silicon carbide seed crystal in the side opposite the first surface.

(34) The apparatus for growing a silicon carbide single crystal as described in (33), wherein the silicon carbide seed crystal-holding means is formed of a carbon material having heat conductivity anisotropy such that the heat conductivity is higher in the heat dissipation direction than in other directions.

(35) The apparatus for growing a silicon carbide single crystal as described in(33) or (34), wherein the vessel wall of the growth vessel through which the silicon carbide seed crystal-holding means passes is formed of a carbon material having heat conductivity anisotropy such that the heat conductivity is lower in the heat dissipation direction than in other directions.

(36) The apparatus for growing a silicon carbide single crystal as described in (33) to (35), wherein both the carbon materials having heat conductivity anisotropy used for forming the silicon carbide seed crystal-holding means and the vessel wall of the growth vessel adjacent to the silicon carbide seed crystal-holding means are pyrograpbite carbon.

BRIEF DESCRIPTION OF THE DRAWINGS

Fig. 1 is a cross section of an apparatus for growing a silicon carbide single crystal by a sublimation method according to the first aspect of the present invention.

Fig. 2 is a cross section of an apparatus for growing a silicon carbide single crystal by a silicon gas carbon reaction-method according to the first aspect of the present invention.

Fig. 3 is a cross section of an apparatus for growing a silicon carbide single crystal by a sublimation method according to the second aspect of the present invention.

Pig. 4 is a cross section of an apparatus for growing a silicon carbide single crystal by a silicon gas carbon reaction method according to the second aspect of the present invention.

Fig. 5 is a cross section showing another example of the apparatus for growing a silicon carbide single crystal by a sublimation method according to the second aspect of the present invention.

Fig. 6 is a cross section of an apparatus for growing a silicon carbide single crystal by a conventional sublimation method.

BEST MODE FOR CARRYING OUT THE INVENTION

According to the first aspect of the present invention, a temperature distribution is provided such that the temperature becomes higher or is the same in the direction away from the seed crystal in the back surface side of the seed crystal, in other words, the temperature gradient is zero or positive, namely, not a negative value, in the direction away from the back surface of the seed crystal or toward the holding member side, whereby the back surface sublimation can be prevented and a crystal reduced in defects can be obtained.

For example, under the temperature and pressure conditions in the formation of a silicon carbide single crystal by a sublimation method, the silicon carbide is readily decomposed or gasified. By the decomposition or gasification, a gas comprising silicon and/or carbon, such as Si, $Si_2C$ and $SiC_2$, namely, a sublimate chemical species is generated from the silicon carbide. As the temperature is higher, the vapor pressure of the sublimate chemical species elevates. Accordingly, if there is a difference in the temperature, the vapor pressure becomes higher in the high temperature part than in the low temperature part to provide a difference in the concentration of the sublimated chemical species. By using the difference in concentration as a driving force, the sublimated chemical species moves from the high temperature part toward the low temperature part and, in the low temperature part reaching supersaturation, silicon carbide deposits. In the result, silicon carbide is transferred in the direction from the high temperature part toward the low temperature part.

The present inventors have found that this transfer of silicon carbide due to the temperature difference is a large cause of the back surface sublimation. More specifically, in conventional methods, as described, for example, in Inst. Phys. Conf. Ser., No. 142, Chapter 11-15 (1996), a temperature gradient such that the temperature is higher on the back surface of the seed crystal than in the holding member side is present and therefore, silicon carbide (as sublimated chemical species) is transferred in the direction toward the holding member from the back surface of seed crystal, as a result, voids are generated on the back surface of the seed crystal as traces or scars of transferred silicon carbide. A larger temperature difference is present through the voids between the bottom of the generated traces on the back surface and the surface of the holding member and therefore, the transfer is accelerated to allow the transfer traces to grow in the depth direction. If the transfer of silicon carbide continues, voids and holes are generated even inside the grown crystal and these holes become piped defects. The back surface sublimation is one of the causes of not only piped defects but also of planar defects generated within the grown crystal.

Accordingly, in the first aspect of the present invention, the temperature on the back surface of the seed crystal becomes higher or is at least the same in the direction away from the back surface, usually, in the side where the holding member is present, whereby the back surface sublimation can be prevented and a high-quality silicon carbide single crystal reduced in defects can be obtained.

The size of the region having the above-described temperature gradient necessary for achieving the object in the first aspect of the present invention may be sufficient insofar as silicon carbide can be prevented from sublimating and transferring from the back surface of the seed crystal. The length in the temperature gradient direction of the region having a temperature gradient may be sufficient if it is, for example, 1 mm, however, the'length is preferably 5 mm or more and in practice, from 1 to 2 cm or more by taking account of the dependency on the heating method.

The value of the temperature gradient for achieving the object of the present intention is not particularly limited and depends on the heating method and means, however, the value is generally from 0 to 20°C/cm, preferably from 2 to 20°C/cm, and for more ensuring a zero or positive temperature gradient, more preferably from 5 to 20°C.

The back surface of the seed crystal is usually put into contact with the holding member and, in this case, the above-described temperature gradient used in the present invention means a temperature gradient from the back surface of the seed crystal to the holding member side. The seed crystal is bonded to the holding member using a bonding agent but may be held using mechanical means. The back surface of the seed crystal is not always bonded with the holding member. In the case where a clearance or a carbon layer or the like for bonding is present between the seed crystal and the holding member, the temperature gradient may be configured with regard to the clearance or the carbon layer or the like for bonding as a part of the holding member and then, the back surface sublimation can be prevented even if voids are present.

The seed crystal (sometimes called "seed crystal substrate" but in the present invention, referred to as "seed crystal") for use in the present invention preferably has the same crystal structure as the grown crystal. For the growth crystal plane, any plane azimuth can be used. For example, C-axis perpendicular plane ($\{0001\}$ plane), C-axis parallel plane ($\{1\bar{1}00\}$ plane), a plane having introduced thereinto an off angle or the like may be used. The surface of the seed crystal substrate is preferably flattened by polishing, so that the quality of the grown single crystal can be improved. The dimension of the seed crystal is not particularly limited but in general, the thickness thereof is from 0.1 to 5 mm. The shape is generally a disk form but is not limited thereto.

In the world, a high-quality silicon carbide single crystal having a large size is required. In intiating the crystal growth, a silicon carbide single crystal piece or the like generated as a by-product in the Acheson method of preparing silicon carbide abrasive grains is generally used, however, the obtained pieces can have only a small size of about 1 cm square. In order to obtain a silicon carbide single crystal having a practical size of about 5 cm or more, the seed crystal must be enlarged. The present invention can be applied to the step of enlarging the seed crystal. In the step of enlarging the size, the size is continuously enlarged until a desired aperture is attained. If the size stops enlarging before the desired size is attained, a procedure of once stopping the growth, cutting the crystal, newly setting it within a crucible and again enlarging the crystal size must be repeated. After the enlargement to a desired size is attained, the crystal may be lengthened by once stopping the crystal growth and cutting and then setting the crystal or by continuing the crystal growth as it is to obtain a single crystal ingot having a large size and a large length. When the present invention is applied to the lengthening step, the back surface sublimation is prevented and the stress from a polycrystal is also inhibited, so that a high-quality crystal can be prepared.

The silicon carbide-forming gas for use in the present invention may be sufficient insofar as it is a gas containing Si and C and can grow a silicon carbide single crystal on a seed crystal, however, the gas is suitably a gas using only Si and/or C as the constituent element, such as Si, $SiC_2$ and $Si_2C$, and containing both Si and C, or a mixture thereof. The gas or gas mixture preferably has an average composition close to the stoichiometric ratio of SiC, though this is not essential. Accordingly, a gas generated by heating and sublimating silicon carbide or a gas formed by passing a vapor generated upon heating of silicon through heated carbon is particularly suitably used. Also, a gas generated by fusing and gasifying a silicon material, reacting it with a carbon material and feeding a silicon material onto the carbon material heated to a temperature higher than the temperature of generating a gas, may be used.

The temperature of the seed crystal, particularly the temperature on the crystal growth surface is preferably within the range from 1,500 to 2,500°C, more preferably from 1,700 to 2,300°C, still more preferably from 1,900 to 2,300°C. At this time, the silicon carbide-forming gas feed part is set to a temperature higher than the temperature on the crystal grcwth surface of the seed crystal, preferably from 5 to 400°C higher, more preferably from 10 to 200°C higher. Due to the presence of difference in the temperature between the silicon carbide-forming gas feed part and the surface of the seed crystal, there arises a difference in the saturated vapor pressure of the silicon carbide-forming gas and the silicon carbide-forming gas in a high concentration at the silicon carbide feed part moves to the vicinity of the seed crystal surface and deposits as a silicon carbide crystal on the seed crystal surface (crystal growth). In the result, the above-described difference in the temperature serves as a driving force of moving the silicon carbide-forming gas within a vessel used for the growth of a silicon carbide single crystal (in the present invention, simply referred to as a "growth vessel") and generating a silicon carbide-forming gas within the growth vessel. Therefore, the temperatures of the silicon carbide-forming gas feed part and the seed crystal and the temperature difference. therebetween are selected to optimize the generation, movement and deposition of a silicon carbide-forming gas.

In the apparatus for growing a silicon carbide single crystal using a seed crystal, the above-described temperature distribution may be realized by the procedure described below using a vertical growth vessel in general. A silicon carbide-forming gas feed part is disposed at the lower part than the seed crystal within the growth vessel and at the same time, separate heating means (heat-generating part) are individually disposed at the upper and lower portions of the seed crystal. When the growth vessel is heated, the silicon carbide-forming gas feed part reaches a temperature higher than that of the seed crystal and the temperature in the upper direction of the seed crystal becomes higher than the temperature of the seed crystal, whereby the temperature gradient from the back surface of the seed crystal toward the upper part can be made zero or a positive value. Also, the heating means (heat generating part) may be disposed throughout the growth vessel and in this case, heating means or cooling means may be designed such that the upper and lower portions of the seed crystal part can be heated to a temperature higher than that of the seed crystal part. The same construction may be employed also in the horizontal growth vessel.

By using the method and apparatus for growing a silicon carbide single crystal according to the first aspect of the present invention, the back surface sublimation can be prevented and even if the crystal growth is continued for a long period of time, the periphery of a single crystal growing from the seed crystal substrate is not overwhelmed with a polycrystal growing from the upper inner wall of the growth vessel, so that a high-quality silicon carbide single crystal reduced in strain and defects and having a large crystal size can be produced.

According to the second aspect of the present invention, the temperature of the growth vessel, in the periphery of the seed crystal is made relatively higher than the surface temperature of the seed crystal, whereby the growth rate of a polycrystal growing on the inner wall of the growth vessel not fixed with a seed crystal in the peripheral part of the seed crystal can be reduced and the single crystal growing on the seed crystal can be prevented from being surrounded with a polycrystal growing in the periphery, as a result, it has been found that generation of strain in the single crystal can be inhibited.

For example, one of factors affecting the transfer speed of a sublimated chemical species from the silicon carbide raw material to the crystal in the sublimation method is the difference in concentration of the sublimate chemical species between the vicinity of the silicon carbide raw material and the vicinity of the surface of the seed crystal substrate. One of causes of generating the concentration difference is the difference in temperature between the silicon carbide raw material and the seed crystal surface. More specifically, since the temperature difference from the silicon carbide raw material is greater in the portion having a lower temperature in the inner wall of the growth vessel than in other portions, a greater difference in concentration of the sublimated chemical species is generated and the sublimated chemical species is fed at a higher rate. As a result, it is considered that the portion having a lower temperature in the inner wall of the growth vessel is larger in the growth rate of crystal. Furthermore, when a temperature distribution is present in each site on the upper inner wall of the growth vessel, a material also moves from the portion having a higher temperature toward the portion having a lower temperature and therefore, it is considered that the growth rate is higher in the portion having a lower temperature. By taking account of this, according to the present invention, a temperature distribution is provided to those sites between the single crystal growing in the seed crystal part and the polycrystal growing on other inner walls, whereby generation of crystal nuclei and the crystal growth rate are controlled at respective sites so as to prevent the single crystal being strained due to envelopment by a polycrystal growing in the periphery of the single crystal growing on a seed crystal.

According to this method, the silicon carbide single crystal is not inhibited by the polycrystal from enlarging the size and therefore, efficient enlargement and simplification of the process can be advantageously attained. After the size is enlarged, if desired, the single crystal may further be grown to a long and high-quality single crystal.

In order to inhibit the growth of a polycrystal on the wall surface in the periphery of the seed crystal, the temperature of the peripheral vessel wall is made from 10 to 400°C higher, preferably from 50 to 300°C higher, than the temperature on the growth surface of the seed crystal. Unless a certain degree of temperature difference is present, the effect of controlling the deposition of silicon carbide or the growth rate may not be attained, however, if the temperature difference is excessively large, the effect is saturated.

Among the peripheral wall surfaces of the seed crystal, a polycrystal growing from the vessel wall present in the back surface side of the seed crystal causes a problem in practice. Particularly, the temperature on the vessel wall facing (opposite or parallel) the back surface of the seed crystal is important. By elevating the temperature on this vessel wall to a temperature from 10 to 400°C higher than the seed crystal, a polycrystal can be prevented, or suppressed, from growing on the peripheral vessel wall including the back surface side of the seed crystal. In the silicon carbide-forming gas feed part side from the seed crystal of the growth vessel, the temperature is rendered higher than the temperature of the seed crystal and the temperature on the peripheral vessel wall is always higher than the temperature of the seed crystal. The vessel wall facing the back surface of the seed crystal generally has a lowest temperature in the back surface side of the seed crystal and therefore, if the temperature of this portion can be made higher than the temperature of the seed crystal, the temperature can be higher in all peripheral portions of the seed crystal than the temperature of the seed crystal.

As described above in the first aspect of the present invention, in the case where the temperature gradient in the back surface side of the seed crystal is zero or a positive value, the temperature on the vessel wall in the back surface side of the seed crystal is generally higher than the temperature of the seed crystal and the object of preventing the growth of a polycrystal in the back surface side of the seed crystal can be achieved in many cases, however, in order to achieve the object in the second aspect of the present invention, it is necessary to provide a temperature difference without fail between the temperature of the seed crystal, particularly on the crystal growth surface and the temperature on the vessel wall surface in the back surface side. This object can be achieved by designing the shape of the growth vessel or the heating or cooling means.

In the case of heating the silicon carbide-forming gas feed part and the back surface side of the seed crystal, the heating is preferably performed to have the lowest temperature at the position of seed crystal.

In order to have a high temperature on the peripheral vessel wall as compared with the seed crystal, a method of heating the inside of the vessel may be used as described above but, in addition, this may also be achieved by setting the heat dissipation from the seed crystal higher than the heat dissipation from the peripheral vessel wall. In other words, when a member having a heat conductivity higher than that of the vessel wall is used for the seed crystal-holding member, cooling of the seed crystal proceeds and a temperature lower than the temperature of the peripheral vessel wall can be realized.

In the case where the seed crystal-holding member is designed to have a high heat dissipation, even if the temperature of the seed crystal is not always lower than the ambient temperature, the temperature of the seed crystal approximates to the temperature on the peripheral vessel wall and an effect of relatively inhibiting the deposition and growth of a polycrystal silicon carbide on the vessel wall surface is provided. This is useful for enhancing the quality and attaining a large size of the silicon carbide single crystal. This invention using a member having such heat dissipation property has no relationship with the temperature distribution and therefore, establishes one independent aspect of the present invention (third aspect).

In the growth vessel for use in the present invention, the portion of housing and heating a raw material or the portion of housing and heating silicon and carbon and growing silicon carbide by the reaction therebetween is suitably formed of a carbon material, usually graphite, however, as long as it is a carbon material, any can be used irrespective of being crystalline or amorphous. For the member of holding the seed crystal in the growth vessel or the peripheral member thereof, all carbon materials may be used irrespective of crystalline or amorphous. For the holding, a method of fixing the seed crystal to the holding member or mechanically combining these may be used.

In the following, a case where a member having higher heat dissipation than that of the peripheral member is used for the member holding the seed crystal to partially create a portion different in the heat dissipation and thereby partially form a low-temperature part in the inner wall part, is described. The materials different in the heat dissipation means that in the case of an isotropic construction material, the construction materials are originally different in heat conductivity and in the case of anisotropic construction material, not only the construction materials are originally different in the heat conductivity but also same construction materials are combined to differ in the direction of material composition. The ratio of the heat conductivity in the portion having high heat dissipation to the heat conductivity in the portion having low heat dissipation is preferably from 1.1 to 1,000, more preferably from 2 to 500, still more preferably from 5 to 300. If the ratio is less than 1.1, a sufficiently large difference in the heat dissipation may not be obtained and the temperature distribution cannot be satisfactorily controlled, whereas if the ratio exceeds 1,000, the temperature difference becomes excessively large due to large difference in the heat dissipation and strain is readily generated in the crystal. In the case of combining materials different in the heat dissipation, from the standpoint of effectively using the raw material, the gap between materials is preferably reduced as much as possible to prevent a growth gas from leaking.

The anisotropic material is described in detail below. The material used is preferably pyrographite carbon (heat conductivity in the C-axis perpendicular direction: 2,000 $W/m^{-1}K^{-1}$, heat conductivity in the C-axis parallel direction: 9.5 $W/m^{-1}K^{-1}$ (300 K)) having anisotropic heat conductivity. In this case, for example, when an anisotropic material is used for the member of holding the seed crystal by making the C-axis perpendicular to the direction from the inside of the growth vessel toward the outside, the heat conductivity in the portion of holding the seed crystal can be made relatively large as compared with the peripheral portion thereof and, by accelerating the heat dissipation from the seed crystal, the temperature distribution can be controlled. Furthermore, when an anisotropic material is used for the peripheral member by disposing it in the direction of the C axis in parallel with the direction from the inside of the growth vessel toward the outside, the heat conductivity in the portion of holding the seed crystal can be made large as compared with the peripheral portion thereof. For the carbon material having anisotropic heat conductivity, a carbon fiber-carbon composite material, so-called CC composite, described in Fukugo Zairyo wo Shiru Jiten (Dictionary for Knowing Composite Material), Agune 115 (1982), may also be used.

In the case of using a growth vessel having disposed therein a material having anisotropic heat conductivity and controlling the inner temperature of the inner wall from the outside, a growth vessel where a carbon material having anisotropic heat conductivity is used at least for the seed crystal-holding member by laying the direction having large heat conductivity parallel to the direction of heat dissipation may be used, for example, a growth vessel where a material having anisotropy in the heat conduction facility is disposed such that the heat conduction facility in the direction from the inside of the growth vessel toward the outside is large or such that the heat conduction facility in the direction toward the inner wall surface of the growth vessel is small. Of course, the present invention includes a case of using a material having anisotropy for the entire growth vessel. By using such a growth vessel and by forming a cut in the growth vessel or externally performing local control from the outer wall of the growth vessel using an additionally disposed cooling device or the like, the temperature distribution within the growth vessel can be locally controlled with good efficiency as compared with the case of using a conventional isotropic homogeneous material.

In the present invention, formation of a cut in the growth vessel and application of additional cooling from the outside are not excluded.

By using the method and the apparatus for growing a silicon carbide single crystal according to the second and third aspects of the present invention, a high-quality silicon carbide single crystal reduced in strain or defects and having a large crystal aperture can be efficiently produced even when the crystal growth is continued for a long period of time, while preventing a polycrystal growing on the upper inner wall of the growth vessel from overwhelming the periphery of the single crystal growing on the seed crystal.

The apparatus for growing a crystal according to the practical embodiment, of the present invention is described below by referring to the attached drawings.

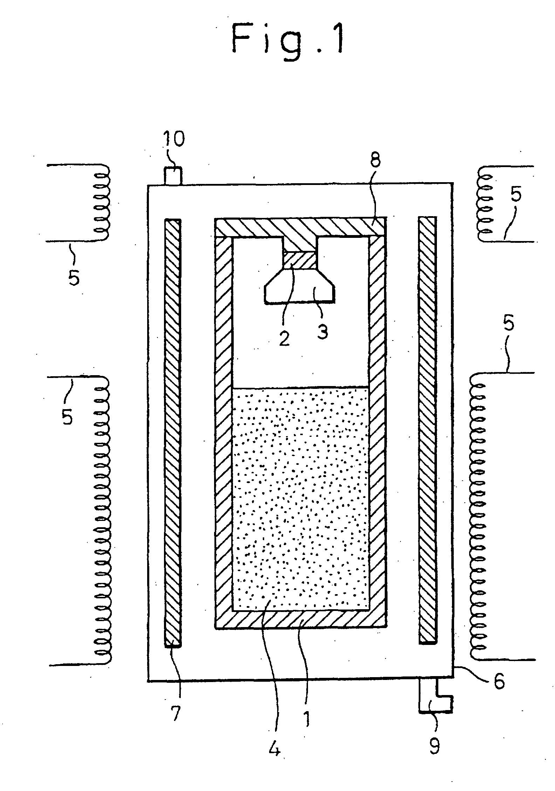

The apparatus for growing a crystal for use in the first aspect of the present invention is described below by referring to Figures 1 to 3.

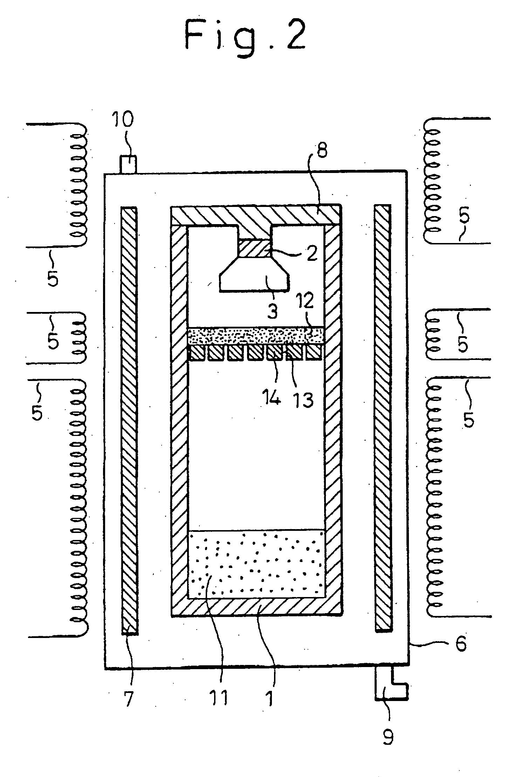

The growth vessel for use in the apparatus for growing a crystal comprises a graphite crucible 1 constituting the silicon carbide-forming gas feed part, which is a portion of housing, and heating a raw material silicon carbide (Fig. 1) or a portion of reacting silicon gas and carbon (Fig. 2), and a graphite-made crucible cap 8 serving as a portion of holding a seed crystal 2 and a peripheral portion. Other than the graphite crucible, any construction material may be used for the portion of housing and heating the raw material silicon carbide 4 or the portion of reacting a silicon gas and carbon is a carbon material insofar as it is a carbon material. Other than the graphite-made crucible cap, any construction material may be used for the portion of holding the seed crystal 2 and the peripheral portion insofar as it is a carbon material. The carbon material as used herein includes all carbon materials irrespective of crystalline or amorphous. For holding the seed crystal, a method of fixing the seed crystal to the holding portion or mechanically combining these may be used.

This growth vessel is installed within a reaction cylinder 6 and an inert gas inlet 10 and a gas outlet 9, are provided in the reaction cylinder so that an inert gas such as argon can be introduced or discharge and also by the balance therebetween, the pressure within the reaction cylinder can be controlled.

The seed crystal for use in the present invention preferably has the same crystal structure as the crystal it is intended to grow. For the growth crystal plane, any plane azimuth may be used. For example, a C-axis perpendicular plane ($\{0001\}$ plane), a C-axis parallel plane ($\{1\bar{1}00\}$ plane), a plane having introduced thereinto an off angle or the like may be used. The surface of the seed crystal substrate is preferably flattened by polishing, so that the quality of the grown single crystal can be improved.

This apparatus for growing a crystal has a high-frequency coil 5 in the high-frequency induction heating system as a heating source for heating the growth vessel. The heating system of the heating source is not limited insofar as it can heat the growth vessel and other than the heat-frequency induction heating system, a resistance heating system and the like may be used. In the case of high-frequency induction system, a current is passed to the high-frequency coil and thereby, an induction current is generated in the growth vessel, as a result, the growth vessel itself, serving as a heating element, is heated. In the case of resistance heating system, a heating element is activated to generated heat and by transmission, radiation or the like, the growth vessel is heated.

As a result of extensive investigations on the method for realizing the temperature gradient of the present invention, it has been found effective to use a heat-growing apparatus having two or more heating moieties and to hold a seed crystal between those heating moieties. More specifically, the relationship with the back surface sublimation was examined by changing the positions of high-frequency induction heating coils 5 and it was confirmed that the back surface sublimation can be inhibited by setting a seed crystal 2 between high-frequency induction heating coils 5. Generally, in the high-frequency induction heating or resistance heating, only the vicinity of the high-frequency induction heating coil or heating element is locally heated and since the temperature in the periphery thereof is low, a U-shaped temperature distribution centered in the high-frequency induction heating coil or heating element is provided, so that the back surface sublimation can be prevented by optimizing the positions of high-frequency induction heating coils. Furthermore, when the surface temperature distribution of a heat insulating material in the vicinity of the seed crystal was measured from the direction of the lateral surface of the growth vessel under the conditions of not causing back surface sublimation, it was confirmed that the temperature gradient from the seed crystal toward the holding member side has a positive gradient.

To have two or more heating moieties means that, in the case of high frequency induction heating system, two or more induction coils are provided and these can be used in the separated state from each other and in the case of resistance heating system, two or more heating elements are provided and these can be used in the separated state from each other. These heating parts may be fixed type or movable type. As described above, the seed crystal must be set at the position of giving a positive temperature gradient from the back surface of the seed crystal toward the holding member. For example, in a crystal growing apparatus having two or more heating parts, it is effective for achieving the above-described temperature gradient to set the seed crystal between . heating parts. In general, the portion close to the heating part has a high a high temperature and the temperature between the heating parts is low as compared with the temperature in the periphery, therefore, the temperature gradient from the back surface of the seed crystal toward the holding member can be made positive and the temperature gradient from the silicon carbide raw material toward the seed crystal surface can be made negative. When a seed crystal is set in this configuration, the temperature of the seed crystal inside the growth vessel can be made relatively low as compared with the peripheral parts, the growth rate of the single crystal growing on the single crystal surface becomes relatively high as compared with the growth rate of a polycrystal growing in the peripheral part, the single crystal is not overwhelmed by the polycrystal, and the crystal size can be efficiently enlarged. Furthermore, the seed crystal is preferably set at the center part on the upper inner wall of the growth vessel distant from the lateral inner wall surface.

In addition to the above-described embodiment of disposing induction heating coils up and down the seed crystal, the objective temperature distribution of the present invention can be realized by adjusting the power of induction heating coil at each site or the shape or position of the member (e.g., carbon) subjected to induction heating such that the seed crystal portion and both sides thereof have different temperatures.

To speak specifically, the temperature on the seed crystal surface is suitably in the range from 1,500 to 2,500°C, preferably from 1,700 to 2,300°C. If the seed crystal temperature is less than 1,500°C or exceeds 2,500°C, polymorphic mixing readily occurs in the deposited crystal. The temperature on the seed crystal surface is more preferably from 1,900 to 2,300°C. When the seed crystal is rotated during the growth, the temperature, gas composition and the like are homogenized and this prevents the growth of an undesired crystal.

In Fig. 1 explaining the sublimation method, the seed crystal 2 is preferably set not to come into contact with the silicon carbide raw material powder 4 and also as close as possible to the silicon carbide raw material powder 4 from the standpoint of facilitating the movement of the reaction gas or keeping the crystal growth plane clean. Furthermore, the seed crystal 2 or the silicon carbide raw material 4 is preferably moved as the crystal grows so as to keep a constant distance between the seed crystal 2 and the silicon carbide raw material powder 4, whereby the growth conditions are stabilized and a higher quality single crystal can be grown. In view of the quality of the grown crystal, the silicon carbide raw material powder is preferably used after cleaning with an acid to remove as much impurities as possible.

According to the present invention, an effect of preventing the back surface sublimation of the seed crystal and the production of a polycrystal is provided, so that the present invention can be used in all processes for producing a silicon carbide single crystal by setting a seed crystal. The method of reacting a silicon material gas with a carbon material and thereby producing a silicon carbide single crystal (hereinafter called a "silicon gas carbon reaction method"), which is another embodiment other than the above-described sublimation method, is described below by referring to Fig. 2.

The silicon gas carbon reaction method which can be used includes a method described in the Mode of Operation of WO99/14405. For example, a method of separately storing a silicon raw material 11 and a carbon raw material 12 (14) within a growth vessel, transferring a gas generated by vaporizing liquid silicon to react with the carbon layer 12 (14), and transferring the generated gas to a seed crystal 2 to deposit and grow a silicon carbide single crystal 3, a method of transferring a silicon gas from the outside of a growth vessel to a carbon layer 12 (14) stored within the growth vessel to react with the carbon layer, transferring the generated gas to the seed crystal 2 to deposit and grow a silicon carbide single crystal 3, a method of directly injecting liquid silicon from the outside of a growth vessel to a carbon layer 12 (14) stored within the growth vessel and transferring the generated gas to a seed crystal 2 to deposit and grow a silicon carbide single crystal 3.

The growth vessel used here is made of carbon or a material comprising only Si and C.

Other conditions such as heating method, temperature-controlling method, seed crystal used and fixing of the seed crystal are the same as those. described above in the sublimation method.

In the silicon gas carbon reaction method, the seed crystal 2 is preferably set not to contact with the carbon raw material 12 (14) and also as close as the carbon raw material 12 (14) from the standpoint of moving the reaction gas and keeping the cleanness of the crystal growth plane. In the silicon gas carbon reaction method, the silicon raw material used preferably has high purity, because the crystal defects and the valence electrons can be easily controlled.

The silicon vapor is contacted with a heated carbon material 12 (14). For the carbon material, various materials including amorphous carbon and graphite may be used, however, in order to grow a high quality silicon carbide, a high-purity carbon material is preferably used. The high purification of the carbon material can be achieved by a high-temperature calcination or a reaction with a halogen-based gas to remove impurities. The carbon material causes a catalytic reaction of the silicon vapor with good efficiency and therefore, as long as the structure can pass a gas, the carbon material can have any structure. For example, the carbon material may be composed of a porous structure or a carbon powder-filled layer. The porous carbon may be obtained by providing through holes on a normal carbon plate but a carbon plate having a high porosity is preferred in view of the catalytic reaction efficiency.

In order to attain good catalytic reaction efficiency, the carbon material may be disposed at multiple stages and these are preferably disposed not to allow the gas flow to linearly pass through but to collide and contact with the carbon materials. For example, in the case of using a normal carbon plate having through holes or a porous carbon plate, these carbon plates are preferably disposed such that the center of each through hole is shifted between respective carbon plates. In the case of using carbon powder, a perforated disk having filled thereon carbon powder is preferably disposed at multiple stages so as to *gain the* collision contact area between a silicon gas phase molecule and carbon.

Similarly to the silicon raw material, the carbon raw material can also be continuously or intermittently added in the consumed portion. For keeping the atmospheric purity inside the crucible, it is preferred to once transport the powder to a preparatory chamber, evacuate the preparatory chamber, purge the chamber with a gas of the growth atmosphere (for example, argon gas) and then feed the carbon powder to a crucible from the preparatory chamber. In the continuous or intermittent feeding of raw material, a method of feeding both carbon and silicon or a method of feeding either one of carbon and silicon may be used. Also, a system of feeding neither carbon nor silicon, namely, a batch system may be used.

In the embodiments shown in Figs. 1 to 5, the inner diameter of the growth vessel is substantially larger than the size of the seed crystal and therefore, the silicon carbide single crystal growing on the surface of the seed crystal 2 can:be grown while it enlarges not only in the thickness direction but also in the width direction, whereby a high-quality and large-size silicon carbide single crystal can be produced. After reaching a large size, the silicon carbide single crystal can be grown only in the longitudinal direction while not changing the size by selecting the shape and the inner diameter of the growth vessel.

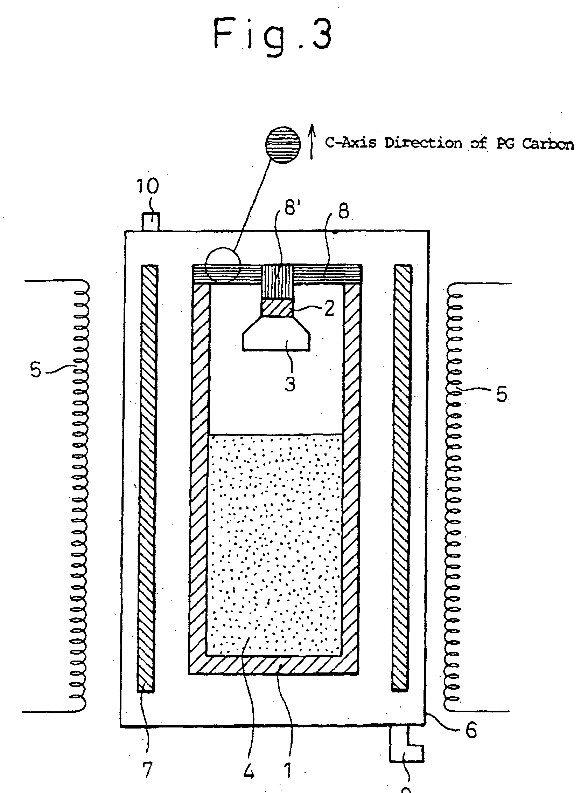

An example of the second aspect of the present invention using a sublimation method is described below by referring to Fig. 3, where the seed crystal-holding member has heat dissipation higher than the heat dissipation of the peripheral members and thereby the growth of a polycrystal from the periphery of the seed crystal is prevented.

The apparatus of Fig. 3 is the same as the apparatus shown in Fig. 1 except for crucible cap 8,8'. The cap 8,8' comprises a cap body 8 and a holding member 8' for the seed crystal 2. By using pyrographite carbon having anisotropy in heat conductivity for the holding member 8' and laying the C axis thereof in the parallel direction, the heat conductivity in the vertical direction from the seed crystal 2 toward the outside of the crucible through the holding member 8' can be made 1,000 times higher than that in the direction perpendicular to the C axis. Accordingly, when pyrographite carbon is used for the cap body 8 while laying the C axis in the vertical direction, the heat conductivity of the crucible cap 8 in the vertical direction can be reduced to 1/1,000 of the heat conductivity of the holding member 8'. As a result, the seed crystal 2 is more cooled than the crucible cap and reaches a lower temperature. In turn, the deposition and growth of a silicon carbide polycrystal on the surface of the crucible cap 8 is prevented or inhibited. Even when an amorphous carbon material other than pyrographite is used for the crucible cap 8, a significant difference in the heat dissipation from the holding member 8' can be provided.

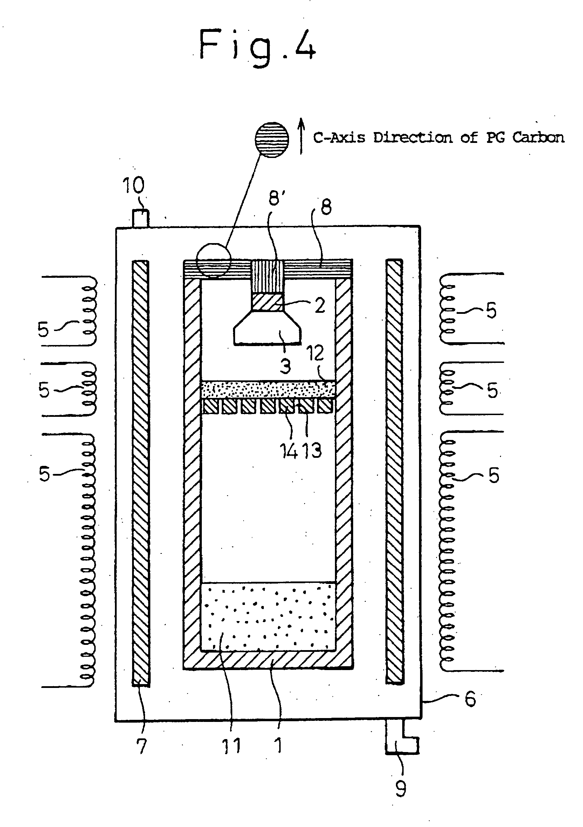

Fig. 4 is a view showing an apparatus for use in the silicon *gas* carbon reaction method, using the same seed crystal-holding member as in Fig. 3. The construction thereof comprises the same apparatus body as in Fig. 2 and the same holding material as in Fig. 3.

EXAMPLES

The present invention is described in greater detail below by referring to specific examples, however, the present invention should not be construed as being limited thereto.

Example 1

This is an example of producing a silicon carbide single crystal by a sublimation method. The production was performed using an apparatus shown in Fig. 1 and. employing a high-frequency heating system. In Fig. 1, a graphite crucible 1 is used for the portion of housing and heating the raw material in a growth vessel. A seed crystal 2 ((0001) plane of 6H-SiC single crystal, diameter: 20 mm, thickness: 1.0 mm) was adhered using a sugar melted on a graphite-made crucible cap 8 and kept adhering by carbonizing the sugar at 500°C. The crystal growth surface of the seed crystal 2 was positioned at a distance of 4 mm from the inner surface of the crucible cap 8.

Within the graphite crucible 1, 170 g of silicon carbide raw material powder 4 (GC-1, #100, produced by Showa Denko K.K.) was housed. The graphite crucible 1 had a diameter of 60 mm and a height of 100 mm. This graphite crucible 1 was wrapped with a heat insulating material 7 and set within a reaction cylinder 6 inside high-frequency heating coils 5. Two high-frequency coils 5 were fixed at upper and lower parts and the crucible was set such that the seed crystal 2 was in a position in the middle of those high-frequency coils. The interval between the two high-frequency coils was 50 mm and the surface of the seed crystal 2 was placed at the position of 25 mm from the lower end of the upper part high-frequency coil 5.

The inside of the reaction cylinder 6 was evacuated from the gas outlet 9 to reduce the pressure to 0.01 torr (1.33 Pa) and after filling argon gas from the inert gas inlet 10 to an atmospheric pressure, again evacuated from the gas outlet 9 to reduce the pressure to 0.0005 torr (0.065 Pa) and thereby expel air inside the reaction cylinder 6. Thereafter, argon gas was filled from the inert gas inlet 10 to an atmospheric pressure, a heat treatment of elevating the temperature of the graphite crucible 1 to 1,500°C and keeping it for 30 minutes was performed, the temperature of the silicon carbide raw material powder 4 and the temperature of the seed crystal 2 were elevated to 2,300°C and 2,100°C, respectively, the argon atmosphere pressure was reduced to 200 torr (26.6 kPa) by the evacuation from the gas outlet 9 and in this state, and a silicon carbide single crystal 3 was grown. The temperature was controlled by measuring the temperature in the outer wall side of the graphite crucible 1 using a radiation thermometer. The temperature on the outer wall surface of the crucible cap 8 was 2,130°C and confirmed to be 30°C higher than the temperature of the seed crystal 2. The temperature gradient was 15°C/cm on average.

After the completion of growth, the inner surface of the crucible cap 8 was observed but growth of a polycrystal large enough to overwhelm the periphery of the single crystal grown on the seed crystal was not confirmed.

The grown crystal had a grown thickness of 4.3 mm in the longitudinal direction and a grown amount of 4.1 mm in the diameter direction. From the peak position by Raman spectrometry and the peak pattern by the x-ray diffraction, this crystal was identified as 6H-SiC single crystal completely free of mixing with other polymorphisms. The grown crystal was cut in parallel to the growth direction and the cross section was observed, as a result, the number of piped defects was small and the density thereof was 10 pieces/cm$^2$. A planar defect was not observed in the grown single crystal. The purity. of the grown crystal was measured by GDMS (glow discharge mass spectroscopy) and the content of elements except for carbon and silicon was found to be 3 ppm or less.

Example 2

This is an example of producing a silicon carbide single crystal by a silicon gas carbon reaction method. The production was performed using an apparatus shown in Fig. 2.

In Fig. 2, a graphite crucible 1 is used for the portion of housing and heating the raw material in a growth vessel. A seed crystal substrate 2 ((0001) plane of 6H-SiC single crystal, diameter: 15 mm, thickness: 1.0 mm) was adhered using a sugar melted on a graphite-made crucible cap 8 and kept adhering by carbonizing the sugar at 500°C. The distance between the inner surface of the crucible cap 8 and the crystal growth surface of the seed crystal 2 was 4 mm.

As shown in Fig. 2, 23 g of silicon raw material 11 (Si grains of semiconductor grade) was housed in the graphite crucible 1. The graphite crucible 1 had an outer diameter of 32 mm, a height of 121 mm and a wall thickness of 4 mm. A carbon plate 14 having a thickness of about 2 mm (having 21 holes of 3 mmφ). was fixed at about 20 mm from the graphite-made crucible cap 8 so as to support carbon powder 12 and thereon, 2.4 g of carbon powder 12 (SHOKALIZER L, produced by Showa Denko K.K.) was filled. The carbon plate 14 used had through holes 13. This graphite crucible 1 was wrapped with a heat insulating material 7 and set within a reaction cylinder 6 inside high-frequency heating coils 5. As shown in the Figure, three high-frequency coils 5 were fixed and the crucible was set such that the seed crystal 2 was at a position in the middle of two high-frequency coils and these two coils were at the positions of the carbon material 12 and the silicon material 11. The distance between the crystal growth surface of the seed crystal 2 and the surface of the carbon material layer 12 was 40 mm and the surface of the seed crystal 2 was positioned at a distance of 25 mm from the lower end of the uppermost high-frequency coil.

The inside of the reaction cylinder 6 was evacuated from the gas outlet 9 to reduce the pressure to 0.01 torr (1.33 Pa) and after filling an argon gas from the inert gas inlet 10 to an atmospheric pressure, again evacuated from the gas outlet 9 to reduce the pressure to 0.0005 torr (0.065 Pa) and thereby expel air inside the reaction cylinder 6. Thereafter, an argon gas was filled from the inert gas inlet 10 to an atmospheric pressure. Then, the pressure was reduced to 10 torr (13.3 Pa) by the evacuation from the gas outlet 9 while heating the graphite crucible 1 and a silicon carbide single crystal 3 was grown while keeping the temperatures of silicon raw material 11, carbon powder 12 and seed crystal 2 at 1,800°C, 2,500°C and 2,000°C, respectively, for 3 hours. The temperature set was controlled by measuring the temperature in the outer wall side of the graphite crucible 1 using a radiation thermometer. The temperature on the outer wall surface of the crucible cap 8 was 2,130°C and the temperature gradient in the back surface side of the seed crystal was 15°C/cm on average.

After the completion of growth, the inner surface of the crucible cap 8 was observed but growth of a polycrystal large enough to overwhelm the periphery of the single crystal grown on the seed crystal was not confirmed.

The grown crystal had a grown amount of 4.8 mm in the longitudinal direction and a grown amount of 4.2 mm in the diameter direction. From the peak position by Raman spectrometry and the peak pattern by the X-ray diffraction, this crystal was identified as 6E-SiC single crystal completely free of mixing of other polymorphisms. The grown crystal was cut in parallel to the growth direction and the cross section was observed, as a result, the number of piped defects was small and the density thereof was 10 pieces/cm$^2$. A planar defect was not observed in the grown single crystal. The purity of the grown crystal was measured by GDMS (glow cischarge mass spectroscopy) and the content of elements except for carbon and silicon was found to be 3 ppm or less.

Comparative Example 1

This is an example of producing a silicon carbide single crystal by a sublimation method. A seed crystal 2 ((0001) plane of 6H-SiC single crystal, diameter: 20 mm, thickness: 1.0 mm) was adhered and held on a graphite-made crucible cap 8.

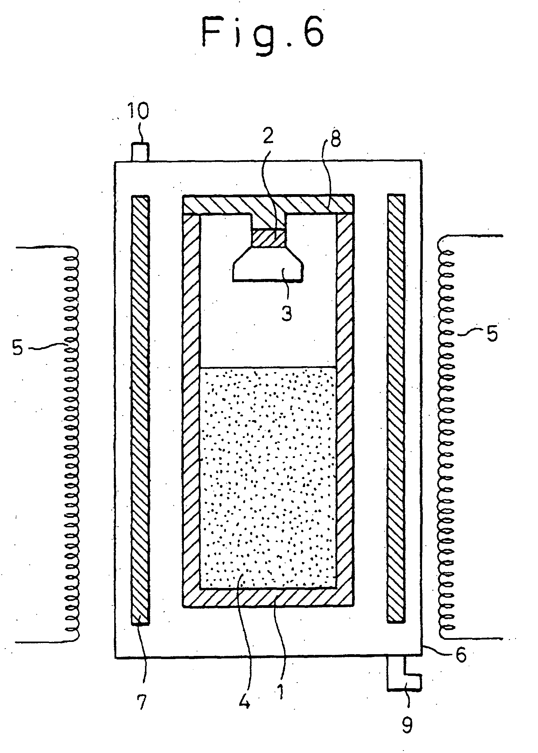

Describing by referring to Fig. 6, 170 g of silicon carbide raw material powder 4 (GC-1, #100, produced by Showa Denko K.K.) was housed in the graphite crucible 1. The graphite crucible 1 had a diameter of 60 mm and a height of 100 mm. This graphite crucible 1 was wrapped with a heat insulating material 7 and set within a reaction cylinder 6 inside high-frequency heating coils 5. One high-frequency coil 5 was used and the upper end thereof was set almost at the same position as the crystal growth surface of the seed crystal 2.

The inside of the reaction cylinder 6 was evacuated from the gas outlet 9 to reduce the pressure to 0.01 torr (1.33 Pa) and after filling an argon gas from the inert gas inlet 10 to an atmospheric pressure, again evacuated from the gas outlet 9 to reduce the pressure to 0.0005 torr (0.065 Pa) and thereby expel air inside the reaction cylinder 6. Thereafter, an argon gas was filled from the inert gas inlet 10 to an atmospheric pressure. Then, a heat treatment of elevating the temperature of the graphite crucible 1 to 1,500°C and keeping it for 30 minutes was performed, the temperature of the silicon carbide raw material powder 4 and the temperature of the seed crystal 2 were elevated to 2,300°C and 2,100°C, respectively, the argon atmosphere pressure was reduced to 200 torr (26.6 kPa) by the evacuation from the gas outlet 9 and in this state, a silicon carbide single crystal 3 was grown. The temperature set was controlled by measuring the temperature in the outer wall side of the graphite crucible 1 using a radiation thermometer. The temperature on the outer wall surface of the crucible cap 8 was 2,000°C and as estimated from the position of the high-frequency heating coil 8, the temperature gradient in the back surface side of the seed crystal 2 was negative (-50°C/cm on average).

After the completion of growth, the crucible cap 8 was taken off and observed, as a result, a polycrystal was grown to overwhelm the periphery of the grown single crystal and, to enlarge the single crystal size, cutting of the polycrystal was necessary.

The grown crystal had a grown thickness of 3.5 mm in the longitudinal direction and a grown amount of 3.2 mm in the diameter direction. The grown crystal was cut in parallel to the growth direction and the cross section was observed, as a result, a large number of piped defects were present and the density thereof was 1,000 pieces/cm$^2$. Also, a large number of planar defects were observed.

Example 3

This is an example of producing a silicon carbide single crystal by a sublimation method. The production was performed using an apparatus shown in Fig. 3. In Fig. 3, a graphite crucible 1 is used for the portion of housing and heating the raw material in a growth vessel. A seed crystal 2 ((0001) plane of 6H-SiC single crystal, diameter: 10 mm, thickness: 1.0 mm) was adhered and held on a holding member 8' of the pyrographite carbon-made crucible cap 8. As shown in Fig. 3, the pyrographite carbon-made crucible cap 8 used had a combination of directivities different in the heat conductivity. The holding member 8 having attached thereto the seed crystal 2 was composed as shown in Fig. 3 to lay the C axis of the pyrographite carbon in the horizontal direction and had high heat conductivity in the direction from the inside toward the outside of the graphite crucible 1. On the other hand, the body of the crucible cap 8 was composed to lay the C axis of the pyrographite carbon in the vertical direction and had low heat conductivity in the direction from the inside toward the outside of the graphite crucible 1. The distance between the crystal growth surface of the seed crystal 2 and the inner surface of the crucible cap 8 body was 4 mm.

Within the graphite crucible 1, 170 g of silicon carbide raw material powder 4 (GC-1, #100, produced by Showa Denko K.K.) was housed. The graphite crucible 1 had a diameter of 60 mm and a height of 100 mm. This graphite crucible 1 was wrapped with a heat insulating material 7 and set within a reaction cylinder 6 inside a high-frequency heating coil 5. The crystal growth surface of the seed crystal 2 was positioned at 20 mm lower from the upper end of the high-frequency coil 5.

The inside of the reaction cylinder 6 was evacuated from the gas outlet 9 to reduce the pressure to 0.01 torr (1.33 Pa) and after filling an argon gas from the inert gas inlet 10 to an atmospheric pressure, again evacuated from the gas outlet 9 to reduce the pressure to 0.0005 torr (0.065 Pa) and thereby expel air inside the reaction cylinder 6. Thereafter, an argon gas was filled from the inert gas inlet 10 to an atmospheric pressure, a heat treatment of elevating the temperature of the graphite crucible 1 to 1,500°C and keeping it for 30 minutes was performed, the temperature of the silicon carbide raw material powder 4 and the temperature of the seed crystal 2 were elevated to 2,300°C and 2,100°C, respectively, the argon atmosphere pressure was reduced to 200 torr (26.6 kPa) by the evacuation from the gas outlet 9 and in this state, a silicon carbide single crystal 3 was grown. The temperature was controlled by measuring the temperature in the outer wall side of the graphite crucible 1 using a radiation thermometer. The temperature in the inner wall side of the crucible cap 8 was 2,100°C at the center portion having high heat dissipation, from 2,150 to 2,250°C at the peripheral portion thereof and 2,200°C on average.

The growth of a polycrystal large enough to overwhelm the periphery of the single crystal grown on the seed crystal was not confirmed.

The grown crystal had a grown thickness of 4.5 mm in the longitudinal direction and a grown amount of 7.0 mm in the diameter direction. From the peak position by Raman spectrometry and the peak pattern by the X-ray diffraction, this crystal was identified as 6H-SiC single crystal completely free of mixing with other polymorphisms.

Example 4

This is an example of producing a silicon carbide single crystal by a silicon gas carbon reaction method. The production was performed using an apparatus shown in Fig. 4.

In Fig. 4, a graphite crucible 1 is used for the portion of housing and heating the raw material in a growth vessel. A seed crystal substrate 2 ((0001) plane of 6H-SiC single crystal, diameter: 7 mm, thickness: 1.0 mm) was adhered and held on a pyrographite carbon-made crucible cap 8. As shown by the C-axis direction of PG carbon in Fig. 4, the pyrographite carbon (PG carbon)-made crucible cap 8 used was composed by a combination of members having different heat conductivity directivities. The member having attached thereto the seed crystal 2 was a member having high heat conductivity, as shown in Fig. 2, in the direction from the inside toward the outside of the graphite crucible 1.

As shown in Fig. 4, 23 g of silicon raw material 11 (Si grains of semiconductor grade) was housed in the graphite crucible 1. The graphite crucible 1 had an outer diameter of 32 mm, a height of 121 mm and a wall thickness of 4 mm. A carbon plate 14 having a thickness of about 2 mm (having 21 holes of 3 mmϕ) was fixed at about 20 mm from the pyrographite carbon-made crucible cap 8 so as to support carbon powder 12 and thereon, 2.4 g of carbon powder 12 (SHOKALIZER L, produced by Showa Denko K.K.) was filled. The carbon plate 14 used had through holes 13. This graphite crucible 1 was wrapped with a heat insulating material 7 and set within a reaction cylinder 6 inside a high-frequency heating container 5.

The inside of the reaction cylinder 6 was evacuated from the gas outlet 9 to reduce the pressure to 0.01 torr and, after filling an argon gas from the inert gas inlet 10 to an atmospheric pressure, again evacuated from the gas outlet 9 to reduce the pressure to 0.0005 torr and thereby expel air inside the reaction cylinder 6. Thereafter, an argon gas was filled from the inert gas inlet 10 to an atmospheric pressure. Then, the pressure was reduced to 10 torr (13.3 Pa) by the evacuation from the gas outlet 9 while heating the graphite crucible 1 and a silicon carbide single crystal 3 was grown while keeping the temperatures of silicon raw material 11, carbon powder 12 and seed crystal 2 at 1,800°C, 2,500°C and 2,000°C, respectively, for 3 hours. The temperature was controlled by measuring the temperature in the outer wall side of the graphite crucible 1 using a radiation thermometer.

The growth of a polycrystal large enough to overwhelm the periphery of the single crystal grown on the seed crystal was not confirmed.

The grown crystal had a grown amount of 5.0 mm in the longitudinal direction and a grown amount of 7.8 mm in the diameter direction. From the peak position by Raman spectrometry and the peak pattern by the X-ray diffraction, this crystal was identified as 6H-SiC single crystal completely free of mixing with other polymorphisms.

Example 5

This is an example of producing a silicon carbide single crystal by a sublimation method. The production was performed using an apparatus shown in Fig. 3 except for using a graphite-made crucible cap 15. A seed crystal 2 ((0001) plane of 6H-SiC single crystal, diameter: 10 mm, thickness: 1.0 mm) was adhered and held on the graphite-made crucible cap 15. The graphite-made crucible cap 15 was composed of a combination of materials different in heat conductivity using a material having high heat conductivity (120 kcal/mhr°C) for the holding member 8' having attached thereto the seed crystal 2 and a material having low heat conductivity (70 kcal/mhr°C) for the body member of the cap 8.

Within the graphite crucible 1, 170 g of silicon carbide raw material powder 4 (GC-1, #100, produced by Showa Denko K.K.) was housed. The graphite crucible 1 had a diameter of 60 mm and a height of 100 mm. This graphite crucible 1 was wrapped with a heat insulating material 7 and set within a reaction cylinder 6 inside a high-frequency heating container 5.

The inside of the reaction cylinder 6 was evacuated from the gas outlet 9 to reduce the pressure to 0.01 torr and, after filling an argon gas from the inert gas inlet 10 to an atmospheric pressure, again evacuated from the gas outlet 9 to reduce the pressure to 0.0005 torr and thereby expel air inside the reaction cylinder 6. Thereafter, an argon gas was filled from the inert gas inlet 10 to an atmospheric pressure, a heat treatment of elevating the temperature of the graphite crucible 1 to 1,500°C and keeping it for 30 minutes was performed, the temperature of the silicon carbide raw material powder 4 and the temperature of the seed crystal 2 were elevated to 2,300°C and 2,200°C, respectively, the argon atmosphere pressure was reduced to 200 torr by the evacuation from the gas outlet 9 and in this state, a silicon carbide single crystal 3 was grown. The temperature was controlled by measuring the temperature in the outer wall side of the graphite crucible 1 using a radiation thermometer. The temperature in the inner wall side of the graphite crucible 1 was 2,200°C at the center portion composed of a material 8' having high heat conductivity, from 2,240 to 2,280°C at the peripheral member and 2,260°C on average.

The growth of a polycrystal large enough to overwhelm the periphery of the single crystal grown on the seed crystal was not confirmed.

The grown crystal had a grown thickness of 3.5 mm in the longitudinal direction and a grown amount of 3.2 mm in the diameter direction. From the peak position by Raman spectrometry and the peak pattern by the X-ray diffraction, this crystal was identified as 6H-SiC single crystal completely free of mixing with other polymorphisms.

Example 6

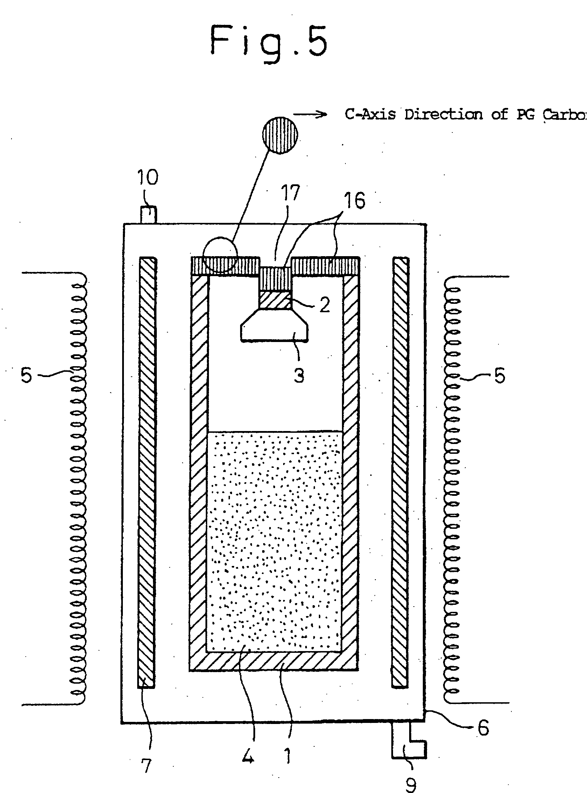

This is an example of producing a silicon carbide single crystal by a sublimation method. The production was performed using an apparatus shown in Fig. 5. In Fig. 5, a graphite crucible 1 is used for the portion of housing and heating the raw material in a growth vessel. As shown by the C-axis direction in Fig. 5, the entire pyrographite carbon-made crucible cap 16 was composed by combining a direction having large anisotropy in the heat conductivity with a direction of heat dissipation from the inside toward the outside of the graphite crucible 1, and a cut 17 for dissipating heat was formed so as to control the temperature. Furthermore, a cooling device (not shown) was used for controlling the temperature from the outside. A seed crystal 2 ((0001) plane of 6H-SiC single crystal, diameter: 10 mm, thickness: 1.0 mm) was adhered and held on the pyrographite carbon-made crucible cap 16. As shown in Fig. 5, the pyrographite carbon-made crucible cap 16 was composed by a single material.

Within the graphite crucible 1, 170 g of silicon carbide raw material powder 4 (GC-1, #100, produced by Showa Denko K.K.) was housed. The graphite crucible 1 had a diameter of 60 mm and a height of 100 mm. This graphite crucible 1 was wrapped with a heat insulating material 7 and set within a reaction cylinder 6 inside a high-frequency heating container 5.

The inside of the reaction cylinder 6 was evacuated from the gas outlet 9 to reduce the pressure to 0.01 torr and, after filling an argon gas from the inert gas inlet 10 to an atmospheric pressure, again evacuated from the gas outlet 9 to reduce the pressure to 0.0005 torr and thereby expel air inside the reaction cylinder 6. Thereafter, an argon gas was filled from the inert gas inlet 10 to an atmospheric pressure, a heat treatment of elevating the temperature of the graphite crucible 1 to 1,500°c and keeping it for 30 minutes was performed, the temperature of the silicon carbide raw material powder 4 and the temperature of the seed crystal 2 were elevated to 2,300°C and 2,200°C, respectively, the argon atmosphere pressure was reduced to 200 torr by the evacuation from the gas outlet 10 and in this state, a silicon carbide single crystal 3 was grown. The temperature was controlled by measuring the temperature in the outer wall side of the graphite crucible 1 using a radiation thermometer. The temperature on the outer wall surface of the graphite crucible 1 was 2,200°C at the cutting part 17, from 2,250 to 2,290°C at the periphery thereof and 2,270°C on average.

The growth of a polycrystal large enough to overwhelm the periphery of the single crystal grown on the seed crystal was not confirmed.

The grown crystal had a grown thickness of 2.5 mm in the longitudinal direction and a grown amount of 3.0 mm in the diameter direction. From the peak position by Raman spectrometry and the peak pattern by the X-ray diffraction, this crystal was identified as 6H-SiC single crystal completely free of mixing with other polymorphisms.

Comparative Example 2

This is an example of producing a silicon carbide single crystal by a sublimation method. The production was performed using an apparatus shown in Fig. 4 except for using a graphite-made cap having uniform heat conductivity (heat conductivity: 100 kcal/mhr°C) by a conventional technique. A seed crystal 2 ((0001) plane of 6H-SiC single crystal, diameter: 10 mm, thickness: 1.0 mm) was adhered and held on the graphite-made cap.

Within a graphite crucible 1 using the same construction material as the cap, 170 g of silicon carbide raw material powder 4 (GC-1, #100, produced by Showa Denko K.K.) was housed. The graphite crucible 1 had a diameter of 60 mm and a height of 100 mm. This graphite crucible 1 was wrapped with a heat insulating material 7 and set within a reaction cylinder 6 inside a high-frequency heating container 5.

The inside of the reaction cylinder 6 was evacuated from the gas outlet 9 to reduce the pressure to 0.01 torr and after filling an argon gas from the inert gas inlet 10 to an atmospheric pressure, again evacuated from the gas outlet 9 to reduce the pressure to 0.0005 torr and thereby expel air inside the reaction cylinder 6. Thereafter, an argon gas was filled from the inert gas inlet 10 to an atmospheric pressure. Then, a heat treatment of elevating the temperature of the graphite crucible 1 to 1,500°C and keeping it for 30 minutes was performed, the temperature of the silicon carbide raw material powder 4 and the temperature of the seed crystal 2 were elevated to 2,300°C and 2,100°C, respectively, the argon atmosphere pressure was reduced to 200 torr by the evacuation from the gas outlet 9 and, in this state, a silicon carbide single crystal 3 was grown. The temperature set was controlled by measuring the temperature in the outer wall side of the graphite crucible 1 using a radiation thermometer. The temperature on the inner wall surface of the graphite crucible 1 was 2,100°C at the center part, from 2,080 to 2,100°C at the periphery thereof and 2,090°C on average.

A polycrystal overwhelmed the periphery of the single crystal and, to enlarge the single crystal aperture, cutting of the polycrystal was necessary. The grown crystal had a grown thickness of 2.5 mm in the longitudinal direction and a grown amount of 1.2 mm in the diameter direction.

**Claims**

1. A method for growing a silicon carbide single crystal on a silicon carbide seed crystal, comprising

   holding a silicon carbide seed crystal within a growth vessel,
   providing a silicon carbide-forming gas feed part in the first surface side of the silicon carbide seed crystal, and
   feeding a silicon carbide-forming gas from the silicon carbide-forming gas feed part to the first surface of the silicon carbide seed crystal, wherein the first surface of the silicon carbide seed crystal has a first temperature, the silicon carbide-forming gas feed part has a second temperature higher than said first temperature and thereby, a silicon carbide single crystal grows on the first surface of the silicon carbide seed crystal,
   wherein the silicon carbide seed crystal has a second surface in the opposite side to the first surface and the temperature gradient in the direction from the first surface of the silicon carbide seed crystal to the second surface is zero or a positive value in the outer vicinity of the second surface of the silicon carbide seed crystal.

2. The method for growing a silicon carbide single crystal as claimed in claim 1, wherein a holding member for holding the silicon carbide seed crystal is present adjacent to said second surface of the silicon carbide seed crystal.

3. The method for growing a silicon carbide single crystal as claimed in claim 1, wherein the region having. said temperature gradient of zero or a positive value has a length of at least 1 mm starting from said second surface of the silicon carbide seed crystal in the direction from the first surface toward the second surface of the silicon carbide seed crystal.

4. The method for growing a silicon carbide single crystal as claimed in claim 1, wherein said temperature gradient is in the range from 0 to 20°C/cm.

5. The method for growing a silicon carbide single crystal as claimed in claim 1, wherein the first surface of the silicon carbide seed crystal has the first temperature and the wall surface of the growth vessel surrounding in the periphery of the silicon carbide seed crystal has a third temperature higher than said first temperature.

6. The method for growing a silicon carbide single crystal as claimed in claim 5, wherein said third temperature is from 10 to 400°C higher than said first temperature.

7. The method for growing a silicon carbide single crystal as claimed in claim 1 wherein, in said silicon carbide-forming gas feed part, the silicon carbide powder is heated to sublimate silicon carbide.

8. The method for growing a silicon carbide single crystal as claimed in claim 1 wherein, in said silicon carbide-forming gas feed part, a vaporized gas from a silicon raw material is passed through heated carbon to form a silicon carbide-forming gas.

9. The method for growing a silicon carbide single crystal as claimed in claim 5, wherein said first temperature is a temperature in the range from 1,500 to 2,500°C.

10. The method for growing a silicon carbide single crystal as claimed in claim 1, wherein a vertical growth vessel is used and heating means are selectively disposed in the upper and lower parts of the silicon carbide seed crystal in the growth vessel or heating means for performing the heating of the upper and lower portions of the silicon carbide seed crystal to a temperature higher than the temperature in the vicinity of the silicon carbide seed crystal is disposed in the growth vessel, such that the silicon carbide-forming gas feed part has a temperature higher than the temperature on the first surface of the silicon carbide seed crystal and said temperature gradient is zero or a positive value and optionally, such that the wall surface surrounding in the periphery of the silicon carbide seed crystal has a temperature higher than the temperature on the first surface of the silicon carbide seed crystal.

11. The method for growing a silicon carbide single crystal as claimed in claim 1, wherein said first temperature is from 1,900 to 2,300°C, said temperature gradient is in the range from 0 to 20°C/cm, the wall surface of the growth vessel facing the second surface of the silicon carbide seed crystal has a third temperature higher than said first temperature, and said third temperature is a temperature from 50 to 300°C higher than said first temperature.

12. The method for growing a silicon carbide single crystal as claimed in claim 1, wherein the silicon carbide single crystal growing on the silicon carbide seed crystal grows while enlarging in width in the direction perpendicular to the thickness direction of the grown crystal.

13. The method for growing a silicon carbide single crystal as claimed in claim 1, wherein the silicon carbide single crystal growing on the silicon carbide seed crystal grows to have substantially the same width in the direction perpendicular to the thickness direction of the grown crystal.

14. The method for growing a silicon carbide single crystal as claimed in claim 1, wherein the silicon carbide single crystal growing on the silicon carbide seed crystal grows while enlarging in width in the direction perpendicular to the thickness direction of the grown crystal and thereafter grows with substantially the same width.

15. A method for growing a silicon carbide single crystal on a silicon carbide seed crystal, comprising

> holding a silicon carbide seed crystal within a growth vessel,
> providing a silicon carbide-forming gas feed part in the first surface side of the silicon carbide seed crystal, and
> feeding a silicon carbide-forming gas from the silicon carbide-forming gas feed part to the first surface of the silicon carbide seed crystal,

wherein the first surface of the silicon carbide seed crystal has a first temperature, the silicon carbide-forming gas feed part has a second temperature higher than said first temperature and, therefore, a silicon carbide single crystal is grown on the first surface of the silicon carbide seed crystal,
wherein the first surface of the silicon carbide seed crystal has a first temperature and the wall surface of the growth vessel surrounding in the periphery of the silicon carbide seed crystal has a third temperature higher than said first temperature.

16. The method for growing a silicon carbide single crystal as claimed in claim 15, wherein a holding member is provided to project inside the growth vessel from the vessel wall of the growth vessel and hold the silicon carbide seed crystal at its distal end, said holding member passes through said first vessel wall, said holding member is higher in the heat dissipation than said surrounding vessel wall and said third temperature is higher than said first temperature.

17. The method for growing a silicon carbide single crystal as claimed in claim 16, wherein said holding member is rendered to have heat dissipation higher than that of said surrounding vessel wall by forming said holding member using a carbon material having heat conductivity anisotropy such that the heat conductivity is higher in the heat dissipation direction than in other directions.

18. The method for growing a silicon carbide single crystal as claimed in claim 15, wherein said third temperature is from 10 to 400°C higher than said first temperature.

19. A method for growing a silicon carbide single crystal, comprising

> holding a silicon carbide seed crystal within a growth vessel,
> providing a silicon carbide-forming gas feed part in the first surface side of the silicon carbide seed crystal, and
> feeding a silicon carbide-forming gas from the silicon carbide-forming gas feed part to the first surface of the silicon carbide seed crystal,
> wherein the first surface of the silicon carbide seed crystal has a; first temperature, the silicon carbide-forming gas feed part has a second temperature higher than said first temperature and, thereby, a silicon carbide single crystal is grown on the first surface of the silicon carbide seed crystal,
> wherein a holding member is provided to project inside the growth vessel from a first vessel wall surface of the growth vessel facing the second surface of the silicon carbide seed crystal in the side opposite said first surface and hold the silicon carbide seed crystal at its distal end, said holding member passes through said first vessel wall, and said holding member is higher in the heat dissipation than the vessel wall.

20. The method for growing a silicon carbide single crystal as claimed in claim 19, wherein said holding member is rendered to have heat dissipation higher than that of said first vessel wall by forming said holding member using a carbon material having heat conductivity anisotropy such that the heat conductivity is higher in the heat dissipation direction than in other directions.

21. The method for growing a silicon carbide single crystal as claimed in claim 20, wherein a carbon material having heat conductivity anisotropy such that the heat conductivity is lower in the heat dissipation direction than in other directions is used for said first vessel wall.

22. The method for growing a silicon carbide single crystal as claimed in claim 21, wherein both said carbon material having heat conductivity anisotropy used for said holding member and said first vessel wall are pyrographite carbon.

23. An apparatus for growing a silicon carbide single crystal on a silicon carbide seed crystal, comprising

> a growth vessel,
> means for holding a silicon carbide seed crystal within the growth vessel, the silicon carbide seed crystal having a first surface and in the opposite side thereof, a second surface,
> a silicon carbide-forming gas feed part for feeding a silicon carbide-forming gas to the first surface of the silicon carbide seed *crystal,* which is provided in the first surface side of the silicon carbide seed crystal,
> first heating means for heating the silicon carbide-forming gas feed part to give a second temperature to the silicon carbide-forming gas feed part, the second temperature being higher than the first temperature on the first surface of the silicon carbide seed crystal, and
> second heating means for heating a portion of the growth vessel in the second surface side of the silicon carbide seed crystal, the temperature gradient in the direction from the first surface toward the second surface of the silicon carbide seed crystal being zero or a positive value in the outer vicinity of the first surface of the silicon carbide seed crystal.

24. The apparatus for growing a silicon carbide single crystal as claimed in claim 23 wherein, in said silicon carbide-forming gas feed part, silicon carbide powder is heated to sublimate silicon carbide and form a silicon carbide-forming gas.

25. The apparatus for growing a silicon carbide single crystal as claimed in claim 23 wherein, in said silicon carbide-forming gas feed part, a vaporized gas from a silicon raw material is passed through heated carbon to form a silicon carbide-forming gas.

26. The apparatus for growing a silicon carbide single crystal as claimed in claim 23, wherein said temperature gradient is in the range from 0 to 20°C/cm.

27. The apparatus for growing a silicon carbide single crystal as claimed in claim 23, wherein the first surface of the silicon carbide seed crystal has a first temperature and the wall surface of the growth vessel surrounding in the periphery of the silicon carbide seed crystal has a third temperature higher than said first temperature.

28. The apparatus for growing a silicon carbide single crystal as claimed in claim 27, wherein said third temperature is from 10 to 400°C higher than said first temperature.

29. An apparatus for growing a silicon carbide single crystal on a silicon carbide seed crystal, comprising

> a growth vessel,
> means for holding a silicon carbide seed crystal within the growth vessel, the silicon carbide seed crystal having a first surface and in the opposite side thereof, a second surface,
> a silicon carbide-forming gas feed part for feeding a silicon carbide-forming gas to the first surface of the silicon carbide seed crystal, which is provided in the first surface side of the silicon carbide seed crystal, and
> first heating means for heating the silicon carbide-forming gas feed part to give a second temperature to the silicon carbide-forming gas feed part, the second temperature being higher than the first temperature on the first surface of the silicon carbide seed crystal,
> wherein the temperature on the wall surface of the growth vessel surrounding in the periphery of the silicon carbide seed crystal is higher than the temperature on the first surface of the silicon carbide seed crystal.

30. The apparatus for growing a silicon carbide single crystal as claimed in claim 29, wherein said silicon carbide seed crystal-holding means is constructed by a member having heat dissipation higher than that of the vessel wall of the growth vessel through which said silicon carbide seed crystal-holding means passes, whereby the temperature on the wall surface of the growth vessel facing the second surface of the silicon carbide seed crystal is made higher than the temperature on the first surface of the silicon carbide seed crystal.

31. The apparatus for growing a silicon carbide single crystal as claimed in claim 30, wherein said silicon carbide seed crystal-holding means is formed of a carbon material having heat conductivity anisotropy such that the heat conductivity is higher in the heat dissipation direction than in other directions.

32. The apparatus for growing a silicon carbide single crystal as claimed in claim 29, wherein the temperature on the wall surface of the growth vessel surrounding in the periphery of the silicon carbide seed crystal is from 10 to 400°C higher than the temperature on the first surface of the silicon carbide seed crystal.

33. An apparatus for growing a silicon carbide single crystal on a silicon carbide seed crystal, comprising

   a growth vessel,
   means for holding a silicon carbide seed crystal within the growth vessel, the silicon carbide seed crystal having a first surface and, on the opposite side thereof, a second surface,
   a silicon carbide-forming gas feed part for feeding a silicon carbide-forming gas to the first surface of the silicon carbide seed crystal, which is provided in the first surface side of the silicon carbide seed crystal, and
   first heating means for heating the silicon carbide-forming gas feed part to give a second temperature to the silicon carbide-forming gas feed part, the second temperature being higher than the first temperature on the first surface of the silicon carbide seed crystal,
   wherein said silicon carbide seed crystal-holding means projects inside the growth vessel from the vessel wall of the growth vessel, passes through the vessel wall and is constructed by a member having heat dissipation higher than that of the first vessel wall surface of the growth vessel facing the second surface of the silicon carbide seed crystal in the side opposite the first surface.

34. The apparatus for growing a silicon carbide single crystal as claimed in claim 33, wherein said silicon carbide seed crystal-holding means is formed of a carbon material having heat conductivity anisotropy such that the heat conductivity is higher in the heat dissipation direction than in other directions.

35. The apparatus for growing a silicon carbide single crystal as claimed in claim 33, wherein the vessel wall of the growth vessel through which said silicon carbide seed crystal-holding means passes is formed of a carbon material having heat conductivity anisotropy such that the heat conductivity is lower in the heat dissipation direction than in other directions.

36. The apparatus for growing a silicon carbide single crystal as claimed in claim 35, wherein both the carbon materials having heat conductivity anisotropy used for forming said silicon carbide seed crystal-holding means and the vessel wall of the growth vessel adjacent to said silicon carbide seed crystal-holding means are pyrographite carbon.

# Fig.1

# Fig.2

# Fig.3

C-Axis Direction of PG Carbon

# Fig.4

↑ C-Axis Direction of PG Carbon

# Fig.5

C-Axis Direction of PG Carbo

# Fig.6

## INTERNATIONAL SEARCH REPORT

| International application No. |
|---|
| PCT/JP99/07299 |

**A. CLASSIFICATION OF SUBJECT MATTER**
Int.Cl$^7$   C30B29/36

According to International Patent Classification (IPC) or to both national classification and IPC

**B. FIELDS SEARCHED**

Minimum documentation searched (classification system followed by classification symbols)
Int.Cl$^7$   C30B1/00-35/00

Documentation searched other than minimum documentation to the extent that such documents are included in the fields searched
Jitsuyo Shinan Koho        1926-1996    Toroku Jitsuyo Shinan Koho  1994-2000
Kokai Jitsuyo Shinan Koho  1971-2000    Jitsuyo Shinan Toroku Koho  1996-2000

Electronic data base consulted during the international search (name of data base and, where practicable, search terms used)
CAS    ONLINE,    "SiC,    silicon(w)carbide,    gradient,    seed,    substrate,
modified(w)Lely, sublimation, heater"
PATOLIS, JICST

**C. DOCUMENTS CONSIDERED TO BE RELEVANT**

| Category* | Citation of document, with indication, where appropriate, of the relevant passages | Relevant to claim No. |
|---|---|---|
| A A | JP, 59-054697, A (Siemens AG), 29 March, 1984 (29.03.84), Claims, 1 to 7 page 2, lower right column, line 19 to page 3, upper left column, line 4 & DE, 3230727, A1 | 1-14, 23-28 19-22,33-36 |
| A A | JP, 05-178698, A (Sharp Corporation), 20 July, 1993 (20.07.93), Claims 2,3,6 Claim 1; Fig. 1    (Family: none) | 15 - 18 29 - 32 |
| A | JP, 09-110584, A (Sanyo Electric Co., Ltd.), 28 April, 1997 (28.04.97), Claims 1,2; Fig. 1   (Family: none) | 19-22, 33-36 |

| ☐ Further documents are listed in the continuation of Box C. | ☐ See patent family annex. |
|---|---|

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search  28 March, 2000 (28.03.00) | Date of mailing of the international search report  04 April, 2000 (04.04.00) |
|---|---|
| Name and mailing address of the ISA/  Japanese Patent Office | Authorized officer |
| Facsimile No. | Telephone No. |

Form PCT/ISA/210 (second sheet) (July 1992)